# FASCICULE DE BREVET EUROPEEN

(11) **EP 3 313 651 B1**
(45) Date de publication et mention de la délivrance du brevet: **10.04.2019**
(21) Numéro de dépôt: 16739232.3
(22) Date de dépôt: 21.06.2016
(51) Int. Cl.: B29B 11/14, B29B 11/16, B29B 15/08, C04B 35/573, D06M 11/79, B29L 31/08, C04B 35/565, B29C 70/00, C04B 35/80, C23C 16/02, C23C 16/26, C04B 35/83, C04B 35/628, C04B 41/81, C04B 41/89, C04B 41/00, C04B 41/45, C04B 41/52, C04B 35/626, C04B 41/53

(54) **PROCÉDÉ DE TRAITEMENT DE FIBRES DE CARBURE DE SILICIUM**
SILICIUMCARBIDFASERBEHANDLUNGSVERFAHREN
SILICON CARBIDE FIBER TREATMENT METHOD

(30) Priorité: 24.06.2015 FR 1555792
(43) Date de publication de la demande: 02.05.2018
(73) Titulaire: Safran Ceramics, 33185 Le Haillan (FR)
(72) Inventeur: LOISON, Sylvie, 33160 Saint Medard en Jalles (FR); HUGUET, Chrystel, 33460 Margaux (FR); DELCAMP, Adrien, 77550 MOISSY-CRAMAYEL (FR); BUET, Emilien, 33160 Saint Medard en Jalles (FR)
(74) Mandataire: Cabinet Beau de Loménie
(86) Numéro de dépôt international: PCT/FR2016/051508
(87) Numéro de publication internationale: WO 2016/207534

(56) Documents cités:
- EP-A1- 0 948 469
- WO-A1-2013/153336
- FR-A1- 2 984 884
- BERTRAND S ET AL: "Influence of strong fiber/coating interfaces on the mechanical behavior and lifetime of Hi-Nicalon/(PyC/SiC)n/SiC minicomposites", JOURNAL OF THE AMERICAN CERAMIC SOCIETY, BLACKWELL PUBLISHING, MALDEN, MA, US, vol. 84, no. 4, 1 avril 2001 (2001-04-01), pages 787-794, XP008152205, ISSN: 0002-7820, DOI: 10.1111/J.1151-2916.2001.TB00742.X [extrait le 2004-12-20]
- E. BUET ET AL: "Influence of chemical and physical properties of the last generation of silicon carbide fibres on the mechanical behaviour of SiC/SiC composite", JOURNAL OF THE EUROPEAN CERAMIC SOCIETY, vol. 32, no. 3, 1 mars 2012 (2012-03-01), pages 547-557, XP055152940, ISSN: 0955-2219, DOI: 10.1016/j.jeurceramsoc.2011.09.023

## Description

### Arrière-plan de l'invention

L'invention concerne un procédé de traitement d'au moins une fibre de carbure de silicium permettant d'améliorer la qualité de la liaison de cette fibre à une couche d'interphase.

La fabrication de pièces en matériau composite renforcées par des fibres de carbure de silicium est bien connue. Elle comprend la réalisation d'une préforme fibreuse à base de fibres de carbure de silicium dont la forme est voisine de celle de la pièce à fabriquer et la densification de la préforme par une matrice.

Il est bien connu que, dans les matériaux composites à renfort fibreux, les caractéristiques de l'interface fibres-matrice ont une grande influence sur les propriétés mécaniques du matériau. Il a été montré qu'un comportement satisfaisant peut être obtenu, en particulier vis-à-vis des chocs et de la propagation des fissures, en formant sur les fibres, avant formation de la matrice, une couche d'interphase de faible épaisseur par exemple en carbone pyrolytique déposé en phase vapeur ou en nitrure de bore. Toutefois, il reste intéressant d'améliorer encore les propriétés mécaniques des pièces en matériau composite.

Les documents WO 98/23555, WO 2013/153336 et FR 2 984 884 sont par ailleurs connus. Ces documents décrivent le traitement de fibres de carbure de silicium par une solution acide. On connait aussi la publication Bertrand et al. "Influence of Strong Fiber/Coating Interfaces on the Mechanical Behavior and Lifetime of Hi-Nicalon/(PyC/SiC)n/SiC Minicomposites".

Il existe donc un besoin pour améliorer encore les propriétés mécaniques des pièces en matériau composite comprenant un renfort fibreux à base de fibres de carbure de silicium.

### Objet et résumé de l'invention

A cet effet, l'invention propose, selon un premier aspect, un procédé selon la revendication 1.

Les inventeurs ont constaté que les fibres de carbure de silicium ayant une teneur en oxygène inférieure ou égale à 1% en pourcentage atomique présentent une couche superficielle qui est responsable de la diminution de la qualité de l'adhésion des fibres à la couche d'interphase. Cette diminution de la qualité de l'adhésion fibre/interphase se traduit par une diminution des propriétés mécaniques de la pièce en matériau composite formée à partir de ces fibres. La couche superficielle comprend typiquement du carbone et au moins un oxycarbure de silicium (composé à base de silicium, de carbone et d'oxygène).

La présente invention propose une solution pour éliminer cette couche superficielle et, par conséquent, pour améliorer la qualité de la liaison fibre/interphase afin d'améliorer les propriétés mécaniques de la pièce en matériau composite obtenue à partir de fibres en carbure de silicium présentant une teneur en oxygène inférieure ou égale à 1% en pourcentage atomique.

L'épaisseur de la couche de silice peut être supérieure ou égale à 1 nm, par exemple à 5 nm, par exemple à 10 nm. Lors de l'étape a), le carbone présent à la surface de la fibre est en tout ou partie éliminé et les oxycarbures comprenant les éléments Si, O et C présents à la surface de la fibre sont en tout ou partie convertis en silice.

La couche de silice est formée lors de l'étape a) par mise en contact de la fibre avec une phase gazeuse oxydante en imposant une température de traitement supérieure ou égale à 600°C, par exemple supérieure ou égale à 650°C, la température de traitement imposée peut par exemple être comprise entre 600°C et 1000°C, par exemple entre 650°C et 1000°C.

La mise en oeuvre de telles valeurs de températures durant le traitement par la phase gazeuse oxydante permet avantageusement d'obtenir une cinétique de formation de la silice relativement rapide.

Dans un exemple de réalisation, la fibre peut, lors de l'étape a), être traitée par de l'air et/ou de la vapeur d'eau. De préférence, la phase gazeuse oxydante qui peut être mise en oeuvre lors de l'étape a) est constituée d'air.

De préférence, la température de traitement imposée lors de l'étape a) peut être comprise entre 900°C et 1000°C.

La mise en oeuvre de telles valeurs de températures durant le traitement par la phase gazeuse oxydante permet avantageusement d'obtenir une cinétique de formation de la silice particulièrement rapide.

De préférence, le milieu liquide acide mis en oeuvre lors de l'étape b) est sous la forme d'une solution aqueuse.

Dans un exemple de réalisation, le milieu liquide acide peut comprendre un mélange d'acide fluorhydrique et d'acide nitrique.

Dans un exemple de réalisation, la couche d'interphase peut être une couche de nitrure de bore ou de carbone pyrolytique. La couche d'interphase est de préférence une couche de nitrure de bore.

Dans un exemple de réalisation, on peut traiter une pluralité de fibres de carbure de silicium présentant chacune une teneur en oxygène inférieure ou égale à 1% en pourcentage atomique.

La présente invention vise également un procédé de fabrication d'une préforme fibreuse comprenant au moins une étape de traitement d'une pluralité de fibres de carbure de silicium par mise en oeuvre d'un procédé tel que décrit plus haut et une étape de formation d'une préforme fibreuse par mise en oeuvre d'une ou plusieurs opérations textiles à partir de ladite pluralité de fibres ainsi traitées.

La présente invention vise également un procédé de fabrication d'une préforme fibreuse comprenant au moins une étape de formation d'une préforme fibreuse par mise en oeuvre d'une ou plusieurs opérations textiles à partir d'une pluralité de fibres de carbure de silicium présentant chacune une teneur en oxygène inférieure ou égale à 1% en pourcentage atomique et une étape de traitement de ladite pluralité de fibres, une fois la préforme formée, par mise en oeuvre d'un procédé tel que décrit plus haut.

La présente invention vise également un procédé de fabrication d'une pièce en matériau composite comprenant au moins une étape de fabrication d'une préforme fibreuse par mise en oeuvre d'un procédé tel que décrit plus haut suivie d'une étape de formation d'au moins une phase de matrice en carbone ou en un matériau céramique densifiant ladite préforme fibreuse.

La pièce en matériau composite peut par exemple être une pièce de turbomachine, par exemple une aube de turbomachine.

### Brève description des dessins

D'autres caractéristiques et avantages de l'invention ressortiront de la description suivante en référence aux dessins annexés, sur lesquels :
- les figures 1A à 1C sont des vues en coupe représentant, de manière schématique et partielle, l'évolution de la structure d'une fibre de carbure de silicium lors de la mise en oeuvre des étapes a) et b) selon l'invention,
- la figure 2 est une photographie du résultat obtenu après mise en oeuvre d'un exemple de procédé selon l'invention,
- la figure 3 est une photographie du résultat obtenu après mise en oeuvre d'un procédé hors invention dans lequel les étapes a) et b) ne sont pas réalisées, et
- la figure 4 illustre les résultats d'un essai comparatif de traction entre une pièce obtenue après mise en oeuvre du traitement selon l'invention et une pièce obtenue après mise en oeuvre d'un traitement hors invention (pas d'étape a)).

### Description détaillée de modes de réalisation

L'invention porte sur le traitement de fibres de carbure de silicium présentant une teneur en oxygène inférieure ou égale à 1% en pourcentage atomique. L'invention porte, par conséquent, sur le traitement de fibres de carbure de silicium relativement pauvres en oxygène, ces fibres se distinguant ainsi des fibres Si-C-O qui présentent une teneur en oxygène en dehors de la plage mentionnée ci-dessus.

Les fibres traitées par le procédé selon l'invention peuvent, par exemple, présenter un ratio atomique C/Si compris entre 1 et 1,1, par exemple compris entre 1 et 1,05. Les fibres de carbure de silicium dites de troisième génération, comme les fibres de type « Hi-Nicalon S » présentent un tel ratio atomique ainsi qu'une teneur en oxygène inférieure ou égale à 1% en pourcentage atomique. D'autres types de fibres de carbure de silicium peuvent être traitées par le procédé selon l'invention comme des fibres de type « Hi-Nicalon » qui présentent un ratio atomique C/Si en dehors des plages mentionnées ci-dessus mais qui présentent une teneur en oxygène inférieure ou égale à 1% en pourcentage atomique.

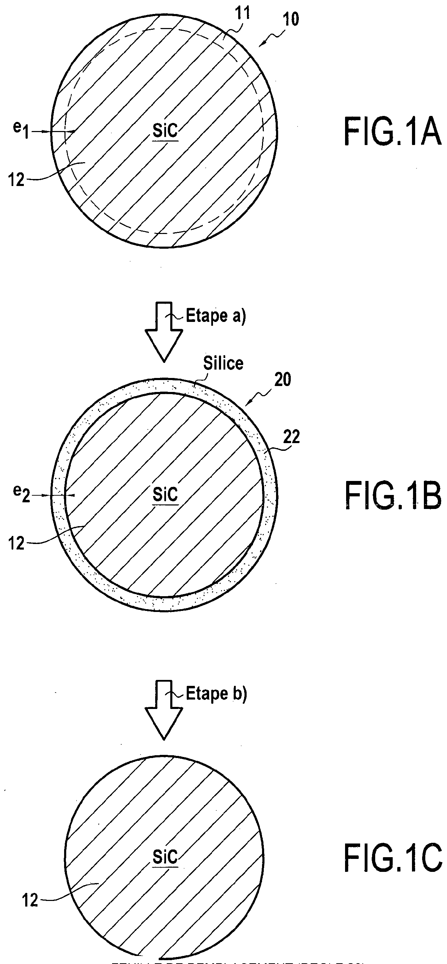

La figure 1A illustre très schématiquement la section d'une fibre 10 de carbure de silicium présentant une teneur en oxygène inférieure ou égale à 1% en pourcentage atomique avant mise en oeuvre du procédé selon l'invention. La fibre de carbure de silicium 10 est constituée d'un coeur 12 en carbure de silicium et d'une couche superficielle 11 située au voisinage de la surface de la fibre 10. La couche superficielle 11 présente un état de surface ainsi qu'un composition hétérogènes et comprend notamment du carbone et au moins un oxycarbure de silicium. La couche superficielle 11 est responsable d'une diminution de la qualité de l'adhésion de la fibre à la couche d'interphase. L'épaisseur e₁ de la couche superficielle 11 peut typiquement être supérieure ou égale à 1 nm, par exemple à 5 nm, par exemple à 10 nm. La couche superficielle 11 est destinée à être éliminée par mise en oeuvre du procédé selon l'invention.

Les fibres de carbure de silicium peuvent être traitées sous quelque forme que ce soit, par exemple fils, mèches, torons, câbles, tissus, feutres, mats et même préformes bi- ou tridimensionnelles. Les fibres de carbure de silicium traitées selon le procédé de l'invention peuvent avantageusement être utilisées pour la réalisation de préformes fibreuses de pièce en matériau composite.

Afin de former la préforme fibreuse, une texture fibreuse peut tout d'abord être obtenue par mise en oeuvre d'une ou plusieurs opérations textiles puis cette texture fibreuse peut être mise en forme afin d'obtenir une préforme fibreuse ayant la forme souhaitée. La texture fibreuse peut être obtenue par tissage tridimensionnel, par exemple à armure "interlock", c'est-à-dire une armure de tissage dans laquelle chaque couche de fils de trame lie plusieurs couches de fils de chaîne avec tous les fils d'une même colonne de trame ayant le même mouvement dans le plan de l'armure. D'autres types de tissage tridimensionnel pourront bien entendu être utilisés pour fabriquer la texture fibreuse. Lorsque la texture fibreuse est réalisée par tissage, le tissage peut être réalisé avec des fils de chaîne s'étendant dans la direction longitudinale de la texture, étant noté qu'un tissage avec des fils de trame dans cette direction est également possible. Différents modes de tissage utilisables pour réaliser la texture fibreuse sont notamment décrits dans le document WO 2006/136755.

La texture fibreuse peut encore être formée par assemblage d'au moins deux structures fibreuses. Dans ce cas, les structures fibreuses peuvent être liées entre elles, par exemple par couture ou aiguilletage. Les structures fibreuses peuvent notamment être chacune obtenue à partir d'une couche ou d'un empilement de plusieurs couches de :
- tissu unidimensionnel (UD),
- tissu bidimensionnel (2D),
- tresse,
- tricot,
- feutre,
- nappe unidirectionnelle (UD) de fils ou câbles ou nappes multidirectionnelle (nD) obtenue par superposition de plusieurs nappes UD dans des directions différentes et liaison des nappes UD entre elles par exemple par couture, par agent de liaison chimique ou par aiguilletage.

Dans le cas d'un empilement de plusieurs couches, celles-ci sont liées entre elles par exemple par couture, par implantation de fils ou d'éléments rigides ou par aiguilletage.

Les fibres en carbure de silicium peuvent être traitées par le procédé selon l'invention avant ou après la réalisation de la préforme.

Le procédé de traitement selon l'invention va à présent être décrit.

La fibre 10 de carbure de silicium présentant une teneur en oxygène inférieure ou égale à 1% en pourcentage atomique est tout d'abord mise en contact avec un milieu oxydant. Suite à cette mise en contact, la couche superficielle 11 est oxydée et est transformée en une couche de silice 22 présentant une épaisseur e₂ qui, dans l'exemple illustré, est sensiblement égale à l'épaisseur e₁ de la couche superficielle 11 (voir figure 1B). L'épaisseur de la couche de silice formée peut, en variante, être supérieure à l'épaisseur de la couche superficielle 11.

Durant l'étape a), la fibre 10 est mise en contact avec une phase gazeuse oxydante comprenant l'élément O. En particulier, la fibre 10 peut, durant l'étape a), être mise en contact avec de l'air ou de la vapeur d'eau. Dans un exemple de réalisation, le traitement de la fibre 10 par la phase gazeuse oxydante peut être réalisé sous une température de traitement comprise entre 600°C et 1000°C, par exemple entre 800°C et 1000°C, de préférence entre 900°C et 1000°C. Le traitement effectué durant l'étape a) peut être effectué à pression atmosphérique ou à une pression inférieure à la pression atmosphérique. On peut ainsi par exemple réaliser l'étape a) sous pression atmosphérique en traitant la fibre 10 par une phase gazeuse oxydante en imposant une température de traitement comprise entre 600°C et 1000°C.

La fibre de carbure de silicium est mise en contact avec la phase gazeuse oxydante lors de l'étape a) pendant une durée supérieure ou égale à 1 minute, par exemple à 5 minutes, par exemple à 10 minutes, par exemple à 30 minutes, cette durée étant par exemple comprise entre 5 minutes et 60 minutes.

Une fois la couche de silice obtenue 22, celle-ci est ensuite éliminée, lors de l'étape b), par dissolution par mise en contact avec un milieu liquide acide comportant au moins de l'acide fluorhydrique. Le milieu liquide acide mis en oeuvre lors de l'étape b) peut par exemple être sous la forme d'une solution aqueuse acide. Avantageusement, le milieu liquide acide est sous la forme d'une solution aqueuse comprenant au moins de l'acide fluorhydrique. La concentration en acide fluorhydrique dans le milieu liquide acide peut avantageusement être supérieure ou égale à 0,5 mol/L.

Dans un exemple de réalisation, le milieu liquide acide peut être sous la forme d'une solution aqueuse comprenant au moins un mélange d'acide fluorhydrique et d'acide nitrique. Lorsque le milieu liquide acide comprend un mélange d'acide fluorhydrique et d'acide nitrique, la concentration en acide fluorhydrique dans le milieu liquide acide peut avantageusement être supérieure ou égale à 0,5 mol/L et la concentration en acide nitrique dans le milieu liquide acide peut avantageusement être supérieure ou égale à 0,5 mol/L. Dans ce cas, la concentration en acide nitrique dans le milieu liquide acide peut par exemple être comprise entre 0,5 mol/L et 5 mol/L.

La température imposée lors de l'étape b) peut être comprise entre 10°C et 100°C, par exemple entre 10°C et 40°C. La durée de mise en contact des fibres avec le milieu liquide acide lors de l'étape b) peut par exemple être supérieure ou égale à 1 minute, par exemple à 5 minutes, par exemple être comprise entre 5 minutes et 60 minutes.

On a représenté à la figure 1C le résultat obtenu après mise en oeuvre des étapes a) et b). Il est dans ce cas obtenu une fibre de carbure de silicium présentant un état de surface ainsi qu'une composition homogènes. Dans l'exemple illustré, on obtient après l'étape b) une élimination de l'intégralité de la couche superficielle 11 sans sensiblement affecter le coeur 12 de la fibre. On obtient après mise en oeuvre des étapes a) et b) une fibre 12 présentant une surface en carbure de silicium pur. Ce résultat se distingue nettement du résultat qui serait obtenu dans le cas où une fibre de carbure de silicium présentant une teneur en oxygène supérieure à 1% en pourcentage atomique (par exemple une fibre « Nicalon ») était traitée par un milieu liquide acide comprenant par exemple un mélange d'acide fluorhydrique et d'acide nitrique. On obtiendrait, en effet, dans ce cas non pas une surface homogène de carbure de silicium mais une couche de carbone en surface de la fibre traitée. En d'autres termes, le fait de réussir à décaper la surface des fibres de carbure de silicium par le traitement selon l'invention est lié à la mise en oeuvre de fibres de carbure de silicium présentant une teneur en oxygène inférieure ou égale à 1% en pourcentage atomique.

Une couche d'interphase est ensuite déposée au contact de la surface de la fibre obtenue après mise en oeuvre des étapes a) et b). Le dépôt de la couche d'interphase directement sur la surface de la fibre est réalisé de manière connue en soi. La fibre traitée par le procédé selon l'invention présente une liaison améliorée avec la couche d'interphase. La couche d'interphase peut être une couche de nitrure de bore (BN) ou une couche de carbone pyrolytique (PyC). L'épaisseur de la couche d'interphase peut par exemple être supérieure ou égale à 200 nm, par exemple être comprise entre 200 nm et 300 nm. On peut déposer sur la couche d'interphase une ou plusieurs couches additionnelles, par exemple en matériau céramique comme le SiBC, BNSi ou le carbure de silicium.

Bien entendu, une pluralité de fibres de carbure de silicium présentant chacune une teneur en oxygène inférieure ou égale à 1% en pourcentage atomique peuvent être traitées simultanément par le procédé selon l'invention.

Une fois la couche d'interphase déposée, on peut ensuite former une pièce en matériau composite à propriétés mécaniques améliorées en densifiant par au moins une phase de matrice une préforme fibreuse comprenant les fibres traitées revêtues de la couche d'interphase. La préforme fibreuse forme le renfort fibreux de la pièce en matériau composite et la phase de matrice est formée dans la porosité de la préforme fibreuse. La phase de matrice peut par exemple être en carbure de silicium ou en carbone.

Cette densification est réalisée de manière connue en soi. La densification de la préforme fibreuse peut ainsi être réalisée par voie liquide (imprégnation par une résine précurseur de la matrice et transformation par réticulation et pyrolyse, le processus pouvant être répété) ou par voie gazeuse (infiltration chimique en phase vapeur de la matrice). L'invention s'applique notamment à la réalisation de pièces en matériau composite à matrice céramique (CMC) formées par un renfort fibreux en fibres de carbure de silicium densifié par une matrice céramique, notamment carbure, nitrure, oxyde réfractaire, etc. Des exemples typiques de tels matériaux CMC sont les matériaux SiC-SiC (renfort en fibres de carbure de silicium et matrice en carbure de silicium). On peut encore réaliser la phase de matrice par infiltration de silicium à l'état fondu (procédé de « Melt-Infiltration).

### Exemples

### Exemple 1

Des fibres de type « Hi-Nicalon S » ont été mises en contact avec une phase gazeuse oxydante constituée d'air en imposant une température de traitement de 650°C pendant une durée de traitement de 45 minutes. Un tel traitement a permis de transformer chimiquement la surface des fibres afin de former une couche de silice de surface. Une analyse par spectrométrie de masse à ionisation secondaire (« secondary ion mass spectrometry » ; « SIMS ») a permis de fournir une estimation de l'épaisseur de la couche de silice ainsi formée. L'épaisseur de la couche de silice a ainsi été estimée à 1,6 nm.

Les fibres oxydées présentant une couche de silice de surface ont alors été réparties en cinq groupes et chaque groupe de fibres a été soumis à un traitement mettant en oeuvre une solution acide différente. Tous les traitements acides ont été réalisés en plongeant les fibres dans un bain de la solution acide pendant une heure sous une température de 30°C. Les compositions des cinq solutions acides qui ont été mises en oeuvre sont répertoriées ci-dessous :
- solution d'acide fluorhydrique à 80g/L,
- solution d'acide fluorhydrique à 448g/L,
- solution comprenant un mélange d'acide fluorhydrique à 80g/L et d'acide nitrique à 180g/L,
- solution comprenant un mélange d'acide fluorhydrique à 80g/L et d'acide nitrique à 325g/L, et
- solution comprenant un mélange d'acide fluorhydrique à 470g/L et d'acide nitrique à 325 g/L.

Une fois ces traitements acides réalisés, une analyse par spectrométrie de masse à ionisation secondaire a permis de confirmer l'élimination de la couche de silice de surface pour les cinq groupes de fibres.

Une couche d'interphase de nitrure de bore a ensuite été formée sur les fibres obtenues par mise en oeuvre de l'oxydation décrite ci-dessus suivie du traitement acide par la solution d'acide fluorhydrique à 448g/L. La couche d'interphase de nitrure de bore a été formée directement sur la surface des fibres de carbure de silicium par mise en oeuvre des conditions opératoires suivantes :
- traitement par une phase gazeuse comprenant du N₂, du NH₃ et du BCl₃,
- température imposée de 1100°C,
- pression imposée de 2 millibars,
- rapport alpha de 1 (correspondant au rapport (débit volumique de NH₃)/(débit volumique de BCl₃)),
- rapport beta de 10 (correspondant au rapport (débit volumique de N₂)/(débit volumique de BCl₃ + débit volumique de NH₃)), et
- débit volumique total de la phase gazeuse de traitement de 367 cm³/minute.

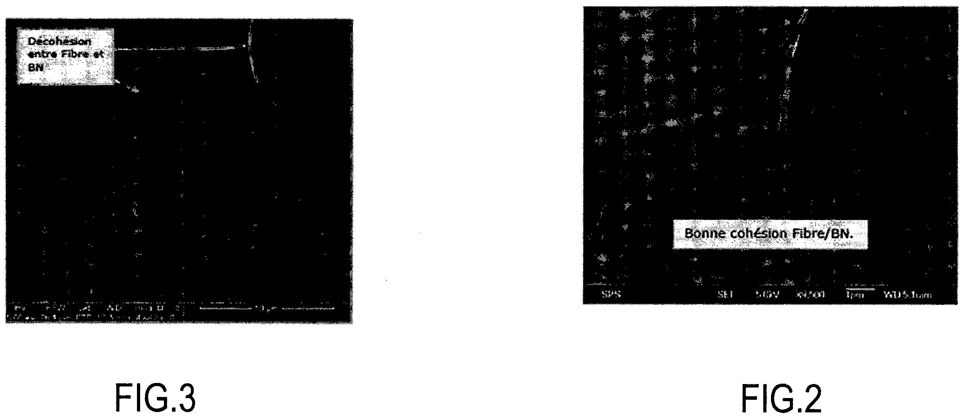

On a représenté à la figure 2 une photographie du résultat obtenu. On observe une bonne cohésion entre les fibres et la couche d'interphase de nitrure de bore. Les fibres revêtues ainsi obtenues constituent un renfort fibreux pour une pièce en matériau composite conférant à ladite pièce des propriétés mécaniques améliorées. La figure 3 est fournie à titre de comparaison et montre que, lorsque le traitement des étapes a) et b) selon l'invention n'est pas réalisé, on observe une décohésion entre les fibres et la couche d'interphase de nitrure de bore. Cette décohésion se traduit par une diminution des propriétés mécaniques de la pièce en matériau composite formée à partir des fibres ainsi revêtues.

### Exemple 2

Un autre essai a été réalisé dans les mêmes conditions que dans l'exemple 1 à la différence que l'oxydation de l'étape a) a été réalisée par mise en contact des fibres avec de l'air sous une température de 1000°C pendant une durée de traitement de 15 minutes. L'épaisseur de la couche de silice formée a dans ce cas été estimée par analyse par spectrométrie de masse à ionisation secondaire à une dizaine de nanomètres environ. On obtient après le traitement par le milieu acide le même état de surface pour les fibres que dans l'exemple 1 et par conséquent des propriétés mécaniques similaires.

### Exemple 3 (comparatif)

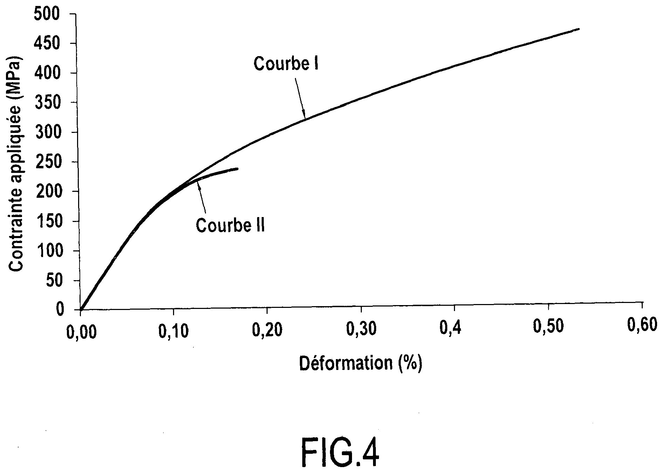

La figure 4 montre les résultats obtenus lors d'un essai de traction entre d'une part une pièce obtenue après traitement des fibres par un procédé selon l'exemple 1 (courbe I) et d'autre part une pièce obtenue après traitement des fibres de la même manière qu'à l'exemple 1 à l'exception que le traitement d'oxydation préalable (étape a)) n'a pas été réalisé (courbe II). On voit que le fait de réaliser le traitement selon l'invention permet avantageusement d'améliorer très significativement l'allongement à rupture de la pièce obtenue.

L'expression « compris(e) entre ... et... » ou « allant de ... à ... » doit se comprendre comme incluant les bornes.

## Revendications

1. Procédé de traitement d'au moins une fibre (10) de carbure de silicium, le procédé comprenant au moins les étapes suivantes :
a) mettre en contact au moins une fibre (10) de carbure de silicium présentant une teneur en oxygène inférieure ou égale à 1% en pourcentage atomique avec une phase gazeuse oxydante pendant une durée supérieure ou égale à 1 minute en imposant une température de traitement supérieure ou égale à 600°C afin de transformer chimiquement la surface de la fibre et former une couche de silice (22) de surface,
b) éliminer la couche de silice (22) formée par mise en contact de la fibre obtenue après mise en oeuvre de l'étape a) avec un milieu liquide acide comportant au moins de l'acide fluorhydrique, et
c) déposer une couche d'interphase sur la surface de la fibre (12) obtenue après mise en oeuvre de l'étape b).

2. Procédé selon la revendication 1, dans lequel la température de traitement imposée lors de l'étape a) est comprise entre 600°C et 1000°C.

3. Procédé selon la revendication 2, dans lequel la température de traitement imposée lors de l'étape a) est comprise entre 900°C et 1000°C.

4. Procédé selon l'une quelconque des revendications 1 à 3, dans lequel la fibre (10) est lors de l'étape a) traitée par de l'air et/ou de la vapeur d'eau.

5. Procédé selon l'une quelconque des revendications 1 à 4, dans lequel le milieu liquide acide comprend un mélange d'acide fluorhydrique et d'acide nitrique.

6. Procédé selon l'une quelconque des revendications 1 à 5, dans lequel la couche d'interphase est une couche de nitrure de bore ou de carbone pyrolytique.

7. Procédé selon l'une quelconque des revendications 1 à 6, dans lequel on traite une pluralité de fibres (10) de carbure de silicium présentant chacune une teneur en oxygène inférieure ou égale à 1% en pourcentage atomique.

8. Procédé de fabrication d'une préforme fibreuse comprenant au moins une étape de traitement d'une pluralité de fibres (10) de carbure de silicium par mise en oeuvre d'un procédé selon la revendication 7 et une étape de formation d'une préforme fibreuse par mise en oeuvre d'une ou plusieurs opérations textiles à partir de ladite pluralité de fibres ainsi traitées.

9. Procédé de fabrication d'une préforme fibreuse comprenant au moins une étape de formation d'une préforme fibreuse par mise en oeuvre d'une ou plusieurs opérations textiles à partir d'une pluralité de fibres (10) de carbure de silicium présentant chacune une teneur en oxygène inférieure ou égale à 1% en pourcentage atomique et une étape de traitement de ladite pluralité de fibres (10), une fois la préforme formée, par mise en oeuvre d'un procédé selon la revendication 7.

10. Procédé de fabrication d'une pièce en matériau composite comprenant au moins une étape de fabrication d'une préforme fibreuse par mise en oeuvre d'un procédé selon la revendication 8 ou 9 suivie d'une étape de formation d'au moins une phase de matrice en carbone ou en un matériau céramique densifiant ladite préforme fibreuse.

11. Procédé selon la revendication 10, la pièce en matériau composite étant une aube de turbomachine.

## Patentansprüche

1. Verfahren zur Behandlung mindestens einer Faser (10) aus Siliciumcarbid, wobei das Verfahren mindestens die folgenden Schritte umfasst:
a) Inkontaktbringen mindestens einer Faser (10) aus Siliciumcarbid, die einen Sauerstoffgehalt aufweist, der kleiner als oder gleich 1 % in Atomprozent ist, mit einer oxidierenden Gasphase für einen Zeitraum, der länger als oder gleich 1 Minute ist, indem eine Behandlungstemperatur auferlegt wird, die höher als oder gleich 600 °C ist, um die Oberfläche der Faser chemisch umzuwandeln und eine Oberflächenschicht aus Siliciumdioxid (22) zu bilden,
b) Entfernen der gebildeten Schicht aus Siliciumdioxid (22) durch Inkontaktbringen der nach Durchführen des Schritts a) erhaltenen Faser mit einem flüssigen, sauren Medium, das mindestens Fluorwasserstoffsäure umfasst, und
c) Abscheiden einer Zwischenphasenschicht auf der Oberfläche der nach Durchführen des Schritts b) erhaltenen Faser (12).

2. Verfahren nach Anspruch 1, wobei die während des Schritts a) auferlegte Behandlungstemperatur zwischen 600 °C und 1000 °C liegt.

3. Verfahren nach Anspruch 2, wobei die während des Schritts a) auferlegte Behandlungstemperatur zwischen 900 °C und 1000 °C liegt.

4. Verfahren nach einem der Ansprüche 1 bis 3, wobei die Faser (10) während des Schritts a) mit Luft und/oder Wasserdampf behandelt wird.

5. Verfahren nach einem der Ansprüche 1 bis 4, wobei das flüssige, saure Medium ein Gemisch von Fluorwasserstoffsäure und Salpetersäure umfasst.

6. Verfahren nach einem der Ansprüche 1 bis 5, wobei die Zwischenphasenschicht eine Schicht aus Bornitrid oder pyrolytischem Kohlenstoff ist.

7. Verfahren nach einem der Ansprüche 1 bis 6, wobei mehrere Fasern (10) aus Siliciumcarbid behandelt werden, die jeweils einen Sauerstoffgehalt aufweisen, der kleiner als oder gleich 1 % in Atomprozent ist.

8. Verfahren zur Herstellung einer Faservorform, umfassend mindestens einen Schritt der Behandlung von mehreren Fasern (10) aus Siliciumcarbid durch Durchführen eines Verfahrens nach Anspruch 7 und einen Schritt der Bildung einer Faservorform durch Durchführen eines oder mehrerer Textilarbeitsvorgänge ausgehend von den mehreren so behandelten Fasern.

9. Verfahren zur Herstellung einer Faservorform, umfassend mindestens einen Schritt der Bildung einer Faservorform durch Durchführen eines oder mehrerer Textilarbeitsvorgänge ausgehend von mehreren Fasern (10) aus Siliciumcarbid, die jeweils einen Sauerstoffgehalt aufweisen, der kleiner als oder gleich 1 % in Atomprozent ist, und einen Schritt der Behandlung der mehreren Fasern (10), nachdem die Vorform gebildet wurde, durch Durchführen eines Verfahrens nach Anspruch 7.

10. Verfahren zur Herstellung eines Teils aus Verbundmaterial, umfassend mindestens einen Schritt der Herstellung einer Faservorform durch Durchführen eines Verfahrens nach Anspruch 8 oder 9, gefolgt von einem Schritt der Bildung mindestens einer Matrixphase aus Kohlenstoff oder aus einem Keramikmaterial, wodurch die Faservorform verdichtet wird.

11. Verfahren nach Anspruch 10, wobei das Teil aus Verbundmaterial eine Turbomaschinenschaufel ist.

## Claims

1. A method of treating at least one silicon carbide fiber (10), the method comprising at least the following steps:
a) putting at least one silicon carbide fiber (10) presenting an oxygen content that is less than or equal to 1% in atomic percentage into contact with an oxidizing gas phase for a duration greater than or equal to 1 min and imposing a treatment temperature greater than or equal to 600°C in order to transform the surface of the fiber chemically and form a surface layer of silica (22);
b) eliminating the resulting silica layer (22) by putting the fiber obtained after performing step a) into contact with an acid liquid medium comprising at least hydrofluoric acid; and
c) depositing an interphase layer on the surface of the fiber (12) obtained after performing step b).

2. A method according to claim 1, wherein the treatment temperature imposed during step a) lies in the range 600°C to 1000°C.

3. A method according to claim 2, wherein the treatment temperature imposed during step a) lies in the range 900°C to 1000°C.

4. A method according to any one of claims 1 to 3, wherein the fiber (10) is treated during step a) with air and/or with steam.

5. A method according to any one of claims 1 to 4, wherein the acid liquid medium comprises a mixture of hydrofluoric acid and of nitric acid.

6. A method according to any one of claims 1 to 5, wherein the interphase layer is a layer of boron nitride or of pyrolytic carbon.

7. A method according to any one of claims 1 to 6, wherein the treatment is applied to a plurality of silicon carbide fibers (10) each presenting an oxygen content that is less than or equal to 1% atomic percentage.

8. A method of fabricating a fiber preform comprising at least a step of treating a plurality of silicon carbide fibers (10) by performing a method according to claim 7 and a step of forming a fiber preform by performing one or more textile operations using said plurality of fibers treated in this way.

9. A method of fabricating a fiber preform comprising at least a step of forming a fiber preform by performing one or more textile operations using a plurality of silicon carbide fibers (10), each presenting an oxygen content that is less than or equal to 1% atomic percentage, and a step of treating said plurality of fibers (10), once the preform has been formed, by performing a method according to claim 7.

10. A method of fabricating a composite material part comprising at least a step of fabricating a fiber preform by performing a method according to claim 8 or claim 9, followed by a step of forming at least one matrix phase of carbon or of ceramic material in order to densify said fiber preform.

11. A method according to claim 10, wherein the composite material part is a turbine engine blade.
